(19) Europäisches Patentamt / European Patent Office / Office européen des brevets

(11) **EP 4 657 756 A1**

(12) **DEMANDE DE BREVET EUROPEEN**

(43) Date de publication:
**03.12.2025 Bulletin 2025/49**

(21) Numéro de dépôt: **25178677.8**

(22) Date de dépôt: **25.05.2025**

(51) Classification Internationale des Brevets (IPC):
**H03K 17/082** *(2006.01)* **H02M 1/00** *(2006.01)*
**H02M 1/08** *(2006.01)* **H03K 17/16** *(2006.01)*

(52) Classification Coopérative des Brevets (CPC):
**H03K 17/0822; H02M 1/0006; H02M 1/0029; H02M 1/08; H02M 1/32; H02M 1/327; H03K 17/166**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **27.05.2024 FR 2405390**

(71) Demandeur: **Safran Electrical & Power**
**31702 Blagnac (FR)**

(72) Inventeurs:
• **SOREL, Hervé**
**77550 MOISSY-CRAMAYEL (FR)**
• **SOREL, Stéphane Claude**
**77550 MOISSY-CRAMAYEL (FR)**

(74) Mandataire: **Argyma**
**14 Boulevard de Strasbourg**
**31000 Toulouse (FR)**

(54) **CIRCUIT AUXILIAIRE POUR UN DISPOSITIF DE COMMANDE D'UN TRANSISTOR À GRILLE ET DISPOSITIF DE COMMANDE ASSOCIÉ**

(57) Un circuit auxiliaire (200b) pour un dispositif de commande d'un transistor de puissance (T2), le circuit auxiliaire (200b) étant configuré pour se connecter à la grille et au drain du transistor à grille (T2), le circuit auxiliaire (200b) étant configuré pour recevoir d'un circuit principal (200a) au moins une commande de commutation (OUT_H, OUT_B) et émettre une commande de grille (GRDV), le circuit auxiliaire (200b) étant configuré pour émettre une tension de désaturation nominale (DESAT), le circuit auxiliaire (200b) comprenant au moins un circuit de comparaison auxiliaire (224) configuré pour comparer une tension représentative d'une tension de drain ($V_{DS}$), à un seuil de désaturation avancé ($V_{th}$) de manière à réaliser une détection anticipée d'une désaturation, le circuit auxiliaire (200b) étant configuré pour modifier la commande de grille (GDRV) en cas de détection anticipée.

[Fig. 5]

FIG. 5

EP 4 657 756 A1

**Description**

**DOMAINE TECHNIQUE**

La présente invention concerne le domaine de l'électronique et, plus particulièrement, un dispositif de commande d'un transistor à grille.

Le changement climatique est une préoccupation majeure pour de nombreux organes législatifs et de régulation à travers le monde. En effet, diverses restrictions sur les émissions de carbone ont été, sont ou seront adoptées par divers Etats. En particulier, une norme ambitieuse s'applique à la fois aux nouveaux types d'avions mais aussi ceux en circulation nécessitant de devoir mettre en oeuvre des solutions technologiques afin de les rendre conformes aux réglementations en vigueur. L'aviation civile se mobilise depuis maintenant plusieurs années pour apporter une contribution à la lutte contre le changement climatique.

Les efforts de recherche technologique ont déjà permis d'améliorer de manière très significative les performances environnementales des avions. La Déposante prend en considération les facteurs impactant dans toutes les phases de conception et de développement pour obtenir des composants et des produits aéronautiques moins énergivores, plus respectueux de l'environnement et dont l'intégration et l'utilisation dans l'aviation civile ont des conséquences environnementales modérées dans un but d'amélioration de l'efficacité énergétique des avions.

Par voie de conséquence, la Déposante travaille en permanence à la réduction de son incidence climatique négative par l'emploi de méthodes et l'exploitation de procédés de développement et de fabrication vertueux et minimisant les émissions de gaz à effet de serre au minimum possible pour réduire l'empreinte environnementale de son activité.

Ces travaux de recherche et de développement soutenus portent à la fois sur les nouvelles générations de moteurs d'aéronefs, l'allègement des appareils, notamment par les matériaux employés et les équipements embarqués allégés, le développement de l'emploi des technologies électriques pour assurer la propulsion, et, indispensables compléments aux progrès technologiques, les biocarburants aéronautiques.

De manière connue, il a été proposé d'équiper un aéronef d'une pluralité de moteurs électriques propulsifs. En pratique, lorsque l'aéronef comprend une source de tension continue pour alimenter le moteur électrique propulsif, par exemple une batterie électrique, il est connu d'utiliser un ou plusieurs onduleurs afin de convertir la tension continue en une tension alternative destinée au moteur électrique propulsif.

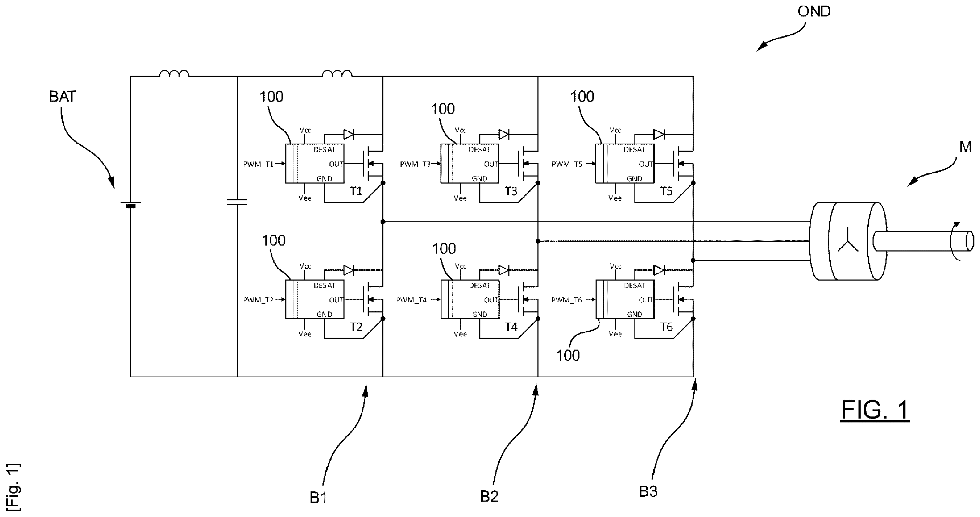

A titre d'exemple, en référence à la figure 1, il est représenté une machine électrique M alimentée par une batterie électrique BAT via un onduleur OND. De manière connue, l'onduleur OND comprend plusieurs bras de pont comportant chacun au moins un transistor à grille T1-T6, généralement du type IGBT ou MOSFET SiC pour améliorer les performances de l'onduleur OND, qui est commandé en ouverture ou en fermeture. En pratique, l'ouverture et la fermeture d'un transistor à grille T1-T6 est pilotée par un dispositif de commande 100 de la grille du transistor à grille T1-T6. Un tel dispositif de commande 100 est connu sous son abréviation anglaise « driver ».

Un tel dispositif de commande 100 permet de commander l'ouverture et la fermeture d'un transistor à grille T1-T6 en fonction d'un signal de commande, généralement du type PWM, émis par un circuit de contrôle (non représenté).

En référence à la figure 1, l'onduleur OND comprend généralement trois bras de pont B1, B2, B3, chaque bras de pont B1, B2, B3 comportant deux branches comportant chacune un transistor à grille T1-T6. Une panne critique peut apparaitre lorsque deux transistors à grille T1-T6 d'un même bras de pont B1, B2, B3 sont fermés en même temps. Aussi, si le premier bras de pont B1 comprend un premier transistor à grille T1 en court-circuit, il est important que le deuxième transistor à grille T2 puisse s'ouvrir sans être endommagé.

Le cas le plus critique survient lorsqu'un court-circuit s'établit à la fermeture du deuxième transistor à grille T2 alors que le premier transistor à grille T1 est déjà en court-circuit. En effet, dans ce cas, le deuxième transistor à grille T2 doit supporter dès sa fermeture la tension de la batterie électrique BAT et doit faire circuler un courant de court-circuit pendant une durée de court-circuit.

En pratique, pour détecter un court circuit, le dispositif de commande surveille une tension de désaturation DESAT du deuxième transistor à grille T2 qui permet de déterminer l'occurrence d'un court-circuit.

Lors d'un court-circuit, le deuxième transistor à grille T2 monte en température et il est nécessaire qu'il puisse s'ouvrir de manière très réactive afin d'éviter sa destruction. A titre d'exemple, un transistor à grille du type IGBT doit s'ouvrir en moins de $10\mu s$ tandis qu'un transistor à grille du type MOSFET SiC doit s'ouvrir en moins de $0,6\mu s$. Par ailleurs, il est important que le deuxième transistor à grille T2 s'ouvre de manière contrôlée sans être trop rapide. En effet, si le deuxième transistor à grille T2 est ouvert trop rapidement (variation trop rapide de la tension de commande), une surtension est générée et peut dépasser la tension d'avalanche du deuxième transistor à grille T2 qui sera détruit du fait de cette surtension.

Il est alors nécessaire de disposer d'un dispositif de commande 100 qui puisse réaliser une ouverture maitrisée lors d'une détection d'une désaturation causée par un court-circuit. Il est d'usage de dire qu'un transistor est désaturé lorsqu'il est empêché de se fermer par l'action du court-circuit. C'est un abus de langage car la désaturation est la conséquence du court-circuit.

**EP 4 657 756 A1**

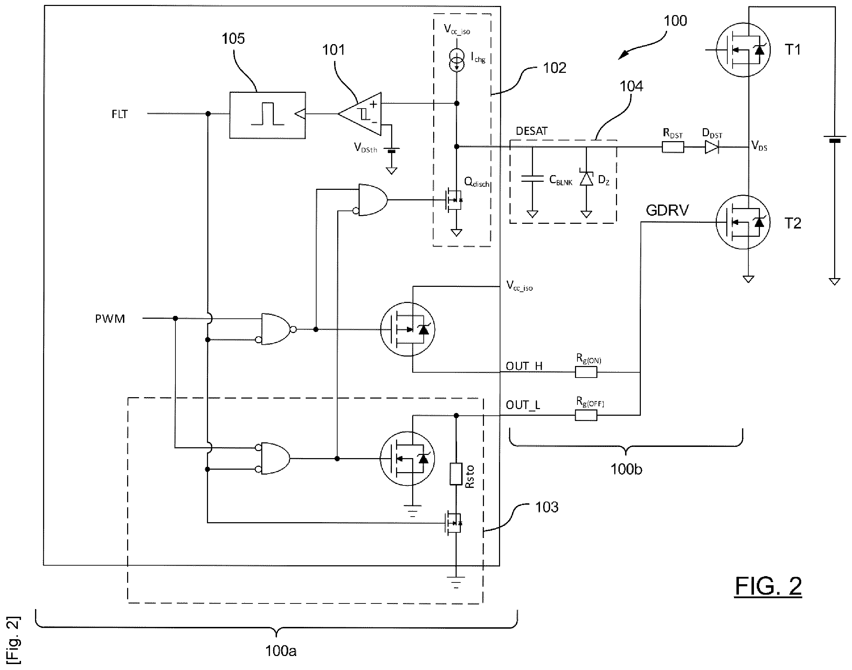

Dans l'art antérieur et en référence à la figure 2, on connait un dispositif de commande 100 compatible pour un transistor à grille du type IGBT ou MOSFET SiC qui comprend un circuit principal 100a, en particulier un circuit intégré, et un circuit auxiliaire 100b, formé de composants électroniques discrets. Le circuit auxiliaire 100b est configuré pour mesurer une tension de drain Vds, qui correspond à la différence de potentiel entre le Drain et la Source dudit transistor de puissance T2, afin de fournir une tension de désaturation DESAT au circuit principal 100a.

Le circuit principal 100a du dispositif de commande 100 selon l'art antérieur comprend une entrée pour recevoir un signal de commande PWM pour déterminer une sortie haute OUT_H et une sortie basse OUT_L qui sont traitées par le circuit auxiliaire 100b afin de déterminer une tension de grille GDRV pour commander le transistor de puissance T2. Le circuit principal 100a comporte une sortie de défaut FLT qui permet de faire remonter la détection d'un court-circuit par traitement de la tension de désaturation DESAT.

Le circuit auxiliaire 100b comporte deux résistances Rg(ON) et Rg(OFF), connectées respectivement à la sortie haute OUT_H et à la sortie basse OUT, qui sont reliées à la grille du transistor de puissance T2 afin de déterminer la tension de grille GDRV.

En particulier, le circuit principal 100a comprend un circuit de comparaison 101 configuré pour déclencher une ouverture de court-circuit lorsque la tension de désaturation DESAT dépasse un seuil de désaturation $V_{DSth}$ pendant une phase où ledit transistor de puissance T2 est commandé ON, c'est-à-dire, en fermeture. De manière préférée, le circuit principal 100a comprend un circuit de source de courant 102 activé lors de la commande ON du transistor de puissance T2 pour réaliser une fonction d'inhibition de la détection de désaturation pendant une durée d'une commutation normale. De manière connue, cela permet de limiter les erreurs lors de la comparaison.

Le circuit principal 100a comprend un circuit de commande en ouverture 103 du transistor de puissance T2, lorsque la tension de désaturation DESAT dépasse le seuil de désaturation $V_{DSth}$ après un temps d'inhibition, de manière à ouvrir lentement le transistor de puissance T2 sans générer de surtension excessive. Une telle fonction est connue de la personne du métier sous son acronyme anglais STO pour « Soft Turn Off ».

De manière connue, le circuit principal 100a comprend un circuit de gestion de défaut 105 configuré pour émettre un signal de défaut FLT en cas de détection d'une désaturation par le circuit de comparaison 101. De préférence, le circuit de gestion de défaut 105 est configuré pour mémoriser une apparition d'un défaut. Le circuit de gestion de défaut 105 est configuré pour être réinitialisé suite à un défaut. Une telle réinitialisation est également appelée « réarmement » du dispositif de commande 100.

Un tel dispositif de commande 100 présente plusieurs inconvénients.

Tout d'abord, le dispositif de commande 100 présente un retard qui ne permet pas de détecter une désaturation de manière suffisamment réactive, ce qui est problématique pour un transistor de puissance du type MOSFET SiC qui peut s'endommager de manière rapide.

En pratique, le retard est composé de :

- un premier retard Tleb déterminé entre la commande en fermeture ON du transistor de puissance T2 et le début de l'inhibition du transistor de puissance T2,

- un deuxième retard configurable Tblank dit « retard d'inhibition » ou « retard de blanking » lors de la détection d'un court-circuit après une commande en fermeture ON,

- un troisième retard Tdesat_out entre le moment où la tension de désaturation DESAT dépasse le seuil de désaturation $V_{DSth}$ et le début de la commande en ouverture OFF du transistor de puissance T2 avec la fonction STO.

En référence à la figure 2, le circuit auxiliaire 100b comporte un circuit d'inhibition 104, appelé aussi « Blanking » qui permet de régler le deuxième retard par la sélection de composants électroniques discrets, en particulier, de la capacité Cblnk.

En pratique, le cumul du premier retard et du troisième retard dépasse à lui seul la durée de court-circuit maximum acceptable pour un transistor de puissance MOSFET SiC (<600ns). Aussi, une solution immédiate serait de remplacer le circuit principal 100a par un circuit spécifique à la commande de MOSFET SIC afin de permettre une détection plus réactive mais cela augmente les coûts de manière très importante.

Outre les inconvénients liés au retard, la technique d'ouverture maitrisée d'un court-circuit par l'augmentation de la résistance de la grille du transistor de puissance T2, oblige à un compromis entre la surtension à l'ouverture d'un court-circuit et les pertes à l'ouverture normale, car la constante de temps pour l'établissement de la tension de grille GDRV à l'ouverture du court-circuit dépend aussi d'une capacité de grille du transistor comprenant une capacité de grille intrinsèque (propre au transistor) et dans certains cas une capacité externe ajoutée pour ralentir l'ouverture d'un court-circuit. De plus, cette capacité de grille ralentit les commutations normales, ce qui augmente les pertes par commutation. Également, cette capacité est chargée et déchargée à chaque période de découpage, ce qui augmente la consommation de la commande de grille et donc la taille de son alimentation. Cela est particulièrement pénalisant avec un transistor de puissance du type MOSFET SiC que l'on utilise à des fréquences de commutation élevées. US20180309433A1 enseigne un circuit pour fermer de manière douce un commutateur de puissance du type Sic MOSFET.

L'invention vise ainsi à éliminer au moins certains de ces inconvénients.

**PRESENTATION DE L'INVENTION**

L'invention concerne un circuit auxiliaire pour un dispositif de commande d'un transistor de puissance, le circuit auxiliaire étant configuré pour se connecter à la grille et au drain du transistor à grille, le circuit auxiliaire étant configuré pour recevoir d'un circuit principal du dispositif de commande au moins une commande de commutation et émettre une commande de grille du transistor à grille, le circuit auxiliaire étant configuré pour émettre une tension de désaturation nominale, représentative d'un court-circuit, au circuit principal de manière à réaliser une détection nominale d'une désaturation.

Le circuit auxiliaire est remarquable par le fait qu'il comporte au moins un circuit de comparaison auxiliaire configuré pour comparer une tension représentative d'une tension de drain, à un seuil de désaturation avancé de manière à réaliser une détection anticipée d'une désaturation, le circuit auxiliaire étant configuré pour modifier la commande de grille en cas de détection anticipée.

Grâce au circuit de comparaison auxiliaire, un court-circuit est détecté de manière anticipée par rapport à une détection d'un court-circuit par un circuit principal, ce qui est avantageux pour commander un transistor à grille du type MOSFET SiC. Cela permet de modifier la commande de grille fournie par le circuit principal pour piloter une ouverture anticipée et éviter la conduction d'un court-circuit pendant un temps trop long qui pourrait endommager le transistor à grille. Une comparaison rapide avec un seuil de désaturation avancé de faible valeur permet une détection réactive. De manière avantageuse, cela permet d'utiliser un circuit principal adapté pour un transistor de puissance du type IGBT dont la réactivité d'ouverture est plus faible tout en conservant ses avantages techniques (isolation, STO, réarmement, etc.) et économiques.

Selon un aspect, le circuit auxiliaire comprend un circuit d'ouverture en deux niveaux configuré pour définir un palier de tension intermédiaire lors d'une commande en ouverture en cas de détection anticipée. L'utilisation d'un palier intermédiaire permet de réaliser une ouverture partielle, ce qui permet de protéger le transistor à grille. Toute risque de surtension à l'ouverture peut ainsi être réduit.

Selon un aspect, le circuit auxiliaire comprend un circuit d'adaptation configuré pour augmenter la commande de sortie du circuit de comparaison auxiliaire jusqu'à la tension de désaturation nominale. Une comparaison rapide avec un seuil de désaturation avancé de faible valeur permet une détection réactive. Le circuit d'adaptation permet d'augmenter cette valeur afin qu'elle appartienne à une plage de valeur classique en tant que tension de désaturation nominale. Autrement dit, cela permet de simuler une tension de désaturation nominale pour le circuit principal alors qu'une tension de désaturation plus faible a été détectée. Ainsi, le circuit principal reçoit une tension de désaturation nominale appartenant à une plage de valeur classique. Cela permet au circuit principal de remplir ses fonctions de manière optimale.

Selon un aspect, le circuit auxiliaire comprend un circuit de retard configuré pour retarder la commande de sortie du circuit de comparaison auxiliaire avant émission de la tension de désaturation nominale. Une comparaison rapide permet une détection réactive. Le circuit de retard permet d'inhiber la détection du circuit principal de manière temporaire. Autrement dit, cela permet de retarder la réaction du circuit principal. Ainsi, le circuit de comparaison agit avant le circuit principal qui reçoit une tension de désaturation nominale à un instant optimal. Cela permet au circuit principal de remplir ses fonctions de manière optimale.

Selon un aspect, le circuit auxiliaire comprend un circuit d'inhibition configuré pour générer un retard de stabilisation de la tension représentative de la tension de drain pour le circuit de comparaison pendant la durée de la commutation.

Selon un aspect, le circuit d'ouverture en deux niveaux comprend une capacité additionnelle. Cela permet de limiter la vitesse de décroissance de la commande de grille à l'ouverture du courant à la fin du palier de tension intermédiaire et donc de limiter la surtension à l'ouverture du transistor T2

Selon un aspect, le circuit d'ouverture en deux niveaux est commandé par la sortie du circuit d'adaptation. Ainsi la commande d'ouverture en deux niveaux intervient avant la commande d'ouverture classique du circuit principal.

Il est également présenté un dispositif de commande d'un transistor à grille comprenant un circuit principal et un circuit auxiliaire tel que présenté précédemment, le circuit auxiliaire étant configuré pour recevoir du circuit principal du dispositif de commande au moins une commande de commutation, le circuit auxiliaire étant configuré pour émettre une tension de désaturation nominale représentative d'un court-circuit au circuit principal de manière à réaliser une détection nominale d'une désaturation.

Selon un aspect, le circuit principal se présente sous la forme d'un circuit intégré et dans lequel le circuit auxiliaire se présente sous la forme de composants discrets. Cela permet d'utiliser un circuit principal dont les fonctions sont éprouvées et dont le coût est réduit tout en optimisant les performances, de manière transparente pour le circuit principal,

# EP 4 657 756 A1

avec le circuit auxiliaire pour un transistor à grille du type MOSFET SiC.

Selon un aspect, le circuit principal comporte un circuit de comparaison configuré pour comparer la tension de désaturation nominale à un seuil de désaturation nominal de manière à réaliser une détection nominale d'une désaturation, le circuit principal étant configuré pour modifier la commande de commutation en cas de détection nominale. Cela permet au circuit principal de remplir une fonction de STO après le circuit auxiliaire c'est-à-dire lorsque le courant de court-circuit a déjà été annulé par l'action du circuit auxiliaire. De préférence, le seuil de désaturation nominal est plus élevé que le seuil de désaturation avancé.

Il est également présenté un convertisseur électrique comprenant une pluralité de transistors à grille, au moins un transistor à grille étant associé à un dispositif de commande tel que présenté précédemment, en particulier, un onduleur. De manière préférée, l'onduleur alimente au moins une machine propulsive ou non propulsive d'un aéronef.

Il est également présenté un procédé de commande d'un transistor de puissance par un circuit auxiliaire tel que présenté précédemment, le procédé comprenant des étapes consistant à :

- Comparer une tension représentative d'une tension de drain, à un seuil de désaturation avancé de manière à réaliser une détection anticipée d'une désaturation, et

- Modifier la commande de grille en cas de détection anticipée.

## PRESENTATION DES FIGURES

L'invention sera mieux comprise à la lecture de la description qui va suivre, donnée à titre d'exemple, et se référant aux figures suivantes, données à titre d'exemples non limitatifs, dans lesquelles des références identiques sont données à des objets semblables.

La figure 1 est une représentation schématique d'un système d'alimentation d'une machine électrique au moyen d'une batterie électrique via un onduleur comportant des dispositifs de commande.

La figure 2 est une représentation schématique d'un dispositif de commande selon l'art antérieur.

La figure 3 est une représentation schématique d'un système d'alimentation d'une machine électrique au moyen d'une batterie électrique via un onduleur comportant des dispositifs de commande selon l'invention.

La figure 4 est une représentation schématique d'un dispositif de commande selon l'invention.

La figure 5 est une représentation schématique d'une première forme de réalisation d'un circuit auxiliaire du dispositif de commande.

La figure 6 est une représentation schématique d'un exemple d'utilisation du circuit auxiliaire de la figure 5.

La figure 7 est une représentation schématique d'un exemple d'utilisation du circuit auxiliaire de la figure 5.

La figure 8 est une représentation schématique d'une autre forme de réalisation d'un circuit auxiliaire du dispositif de commande.

La figure 9 est une représentation schématique d'une autre forme de réalisation d'un circuit auxiliaire du dispositif de commande.

La figure 10 est une représentation schématique d'une autre forme de réalisation d'un circuit auxiliaire du dispositif de commande.

La figure 11 est une représentation schématique d'une autre forme de réalisation d'un circuit auxiliaire du dispositif de commande.

La figure 12 est une représentation schématique d'une autre forme de réalisation d'un circuit auxiliaire du dispositif de commande.

Il faut noter que les figures exposent l'invention de manière détaillée pour mettre en oeuvre l'invention, lesdites figures pouvant bien entendu servir à mieux définir l'invention le cas échéant.

## DESCRIPTION DETAILLEE DE L'INVENTION

L'invention va être présentée dans le contexte aéronautique pour une machine électrique propulsive d'aéronef. Dans un tel contexte, la sécurité de fonctionnement est primordiale. Il va de soi que l'invention s'applique également à une machine électrique non propulsive d'aéronef. Il va néanmoins de soi que l'invention s'applique à d'autres domaines techniques dans le transport ou l'industrie pour tout type de machine électrique.

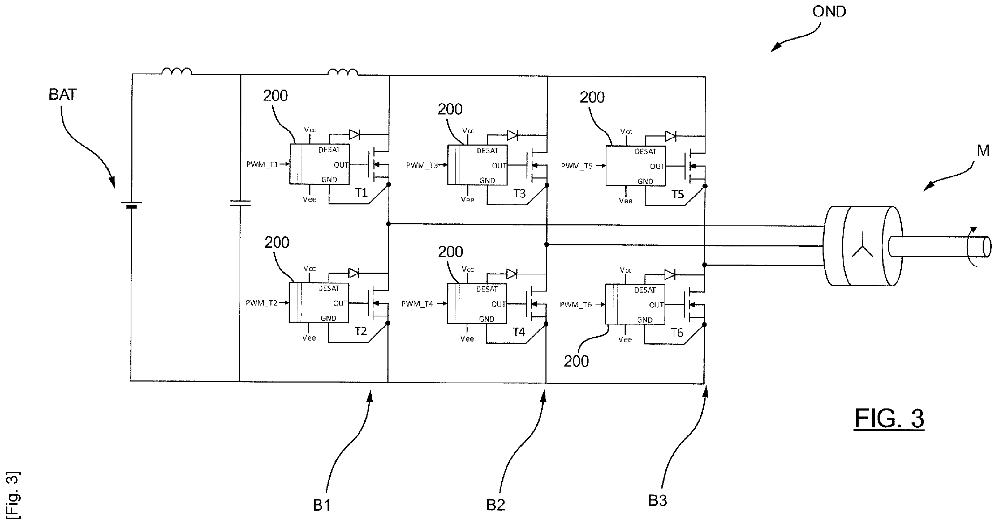

En référence à la figure 3, il est représenté une machine électrique M alimentée par une batterie électrique BAT via un onduleur OND. De manière connue, l'onduleur OND comprend plusieurs bras de pont comportant chacun au moins un transistor à grille T1-T6, généralement du type IGBT ou MOSFET, qui est commandé en ouverture ou en fermeture. Dans cet exemple, le transistor à grille est un transistor de puissance à grille de type MOSFET, en particulier, de technologie silicium SiC. Comme expliqué précédemment, un tel transistor de puissance doit être ouvert de manière réactive sans générer de surtension dépassant sa tension de claquage (« breakdown » en langue anglaise).

En référence à la figure 3, chaque transistor à grille T1-T6 est associé à un dispositif de commande 200 de grille configuré pour commander l'ouverture et la fermeture de chaque transistor à grille T1-T6. Un tel dispositif de commande 200 est connu sous son abréviation anglaise « driver ».

Le dispositif de commande 200 permet de commander l'ouverture (correspondant à un état non passant ou OFF) et la fermeture (correspondant à un état passant ou ON) d'un transistor à grille T1-T6 en fonction d'un signal de commande, généralement du type PWM, émis par un circuit de contrôle (non représenté).

En référence à la figure 3, l'onduleur OND comprend trois bras de pont B1, B2, B3, chaque bras de pont B1, B2, B3 comportant deux branches comportant chacune un transistor à grille T1-T6. Une panne critique de type court-circuit de bras peut apparaitre lorsque l'un des deux transistors à grille T1-T6 est commandé en fermeture ON alors que l'autre transistor du même bras de pont B1, B2, B3 est déjà défectueux. Aussi, si le premier bras de pont B1 comprend un premier transistor à grille T1 en court-circuit, il est important que le deuxième transistor à grille T2 puisse s'ouvrir sans être endommagé.

Comme présenté dans le préambule, le cas le plus critique survient lorsqu'un court-circuit s'établit à la fermeture du deuxième transistor à grille T2 alors que le premier transistor à grille T1 est déjà en court-circuit. En effet, dans ce cas, le deuxième transistor à grille T2 fonctionne en mode saturé dès l'instant d'établissement du court-circuit à la fermeture du deuxième transistor à grille T2. Le deuxième transistor à grille T2 doit supporter en même temps la tension du réseau générée par la batterie électrique BAT ou par toute autre source d'alimentation et faire circuler un courant de court-circuit pendant une durée de court-circuit. Dans ce cas, une forte puissance est dissipée sous forme thermique dans le deuxième transistor à grille T2 qui conduit très rapidement à un échauffement excessif de celui-ci et à sa destruction.

Il va être présenté un dispositif de commande 200 pour la commande du deuxième transistor à grille T2. De manière préférée, tous les dispositifs de commande 200 sont analogues ou identiques.

Dispositif de commande 200

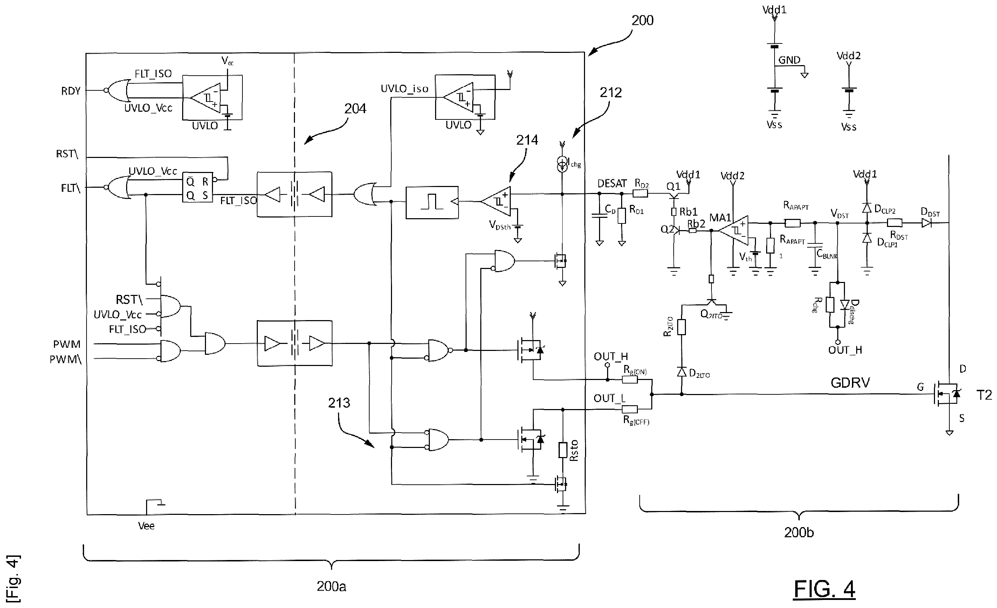

En référence à la figure 4, il est représenté un dispositif de commande 200 comportant un circuit principal 200a et un circuit auxiliaire 200b.

Le dispositif de commande 200 comprend en outre une première source de tension connectée entre un premier potentiel positif Vdd1 et un potentiel de référence GND. Le potentiel de référence GND est relié à la source du transistor de puissance T2. Le dispositif de commande 200 comprend une deuxième source de tension connectée entre le potentiel de référence GND et un potentiel d'alimentation Vss qui est négatif par rapport au potentiel de référence GND. Le dispositif de commande 200 comprend une troisième source de tension connectée entre un deuxième potentiel positif Vdd2 et le potentiel d'alimentation Vss, le deuxième potentiel positif Vdd2 étant positif par rapport au potentiel d'alimentation Vss.

Circuit principal 200a

De manière préférée, le circuit principal 200a correspond à un circuit principal selon l'art antérieur, en particulier, sous la forme d'un circuit intégré adapté pour détecter une désaturation d'un transistor de puissance du type IGBT. Un tel circuit principal 200a possède un coût réduit et de nombreuses fonctions intégrées. Ses performances sont éprouvées et compatibles avec le secteur aéronautique.

Le circuit principal 200a comprend une entrée pour recevoir un signal de commande PWM pour déterminer une sortie haute OUT_H et une sortie basse OUT_L qui sont traitées par le circuit auxiliaire 200b afin de déterminer une commande de grille GDRV, en particulier une tension de grille, pour commander le transistor de puissance T2. La sortie haute OUT_H et la sortie basse OUT_L sont des commandes de commutation. Un tel circuit principal 200a est dit « splitté » car les deux sorties de commutation OUT_H et OUT_L sont séparées mais il va de soi qu'elles pourraient être mutualisées avec une unique sortie de commutation. Le circuit principal 200a peut ainsi comprendre une sortie de commutation commune de type push-pull, connectée à la grille du transistor par deux résistances Rg(ON) et Rg(Off) et des diodes (non représentées) pour différentier la commande à l'état passant et la commande à l'état bloqué.

Le circuit principal 200a comporte une sortie de défaut FLT qui permet de faire remonter la détection d'un court-circuit par traitement d'une tension de désaturation nominale DESAT fournie par le circuit auxiliaire 200b.

En particulier, le circuit principal 200a comprend un circuit de comparaison nominale 214 configuré pour comparer la tension de désaturation nominale DESAT à un seuil de désaturation nominal $V_{DSth}$ de manière à réaliser une détection nominale d'une désaturation. Le circuit principal 200a comprend un circuit de commande en ouverture 213 du transistor de puissance T2. Autrement dit, le circuit de commande en ouverture 213 est configuré pour modifier les commandes de commutation OUT_H, OUT_L en cas de détection nominale, c'est-à-dire, lorsque la tension de désaturation nominale DESAT dépasse le seuil de désaturation nominal $V_{DSth}$ pendant une phase où ledit transistor de puissance T2 est commandé en fermeture ON afin de déclencher une ouverture de court-circuit.

Le circuit principal 200a comprend un circuit de source de courant 212 activé lors de la commande en fermeture ON du transistor de puissance T2 pour réaliser une fonction d'inhibition de la détection de désaturation pendant une durée d'une commutation normale. De manière connue, cela permet de limiter les erreurs lors de la comparaison.

Le circuit de commande en ouverture 213 est configuré pour ouvrir lentement le transistor de puissance T2 sans générer de surtension excessive. Une telle fonction est connue de la personne du métier sous son acronyme anglais STO pour « Soft Turn Off ». Le circuit principal 200a comprend en outre une barrière d'isolation 204 de manière à assurer la sécurité et le bon fonctionnement électrique d'un bras d'onduleur. Le circuit principal 200a permet en outre une mémorisation des défauts à travers la barrière d'isolation, un réarmement, etc.

Le circuit principal 200a est formé par un circuit intégré pour transistor de puissance IGBT dont les fonctions sont isolées et sont référencées au potentiel de référence GND et alimentées par les tensions Vdd1, Vss. Un tel circuit principal 200a est connu de la personne du métier et ne sera pas présenté plus en détails.

Circuit auxiliaire 200b

En référence à la figure 4, le circuit auxiliaire 200b est configuré pour mesurer une tension de drain $V_{DS}$, qui correspond à la différence de potentiel entre le Drain et la Source dudit transistor de puissance T2, afin de fournir une tension de désaturation nominale DESAT au circuit principal 200a. Dans cet exemple, le circuit auxiliaire 200b comporte deux résistances Rg(ON) et Rg(OFF), connectées respectivement à la sortie haute OUT_H et à la sortie basse OUT_L, qui sont reliées à la grille du transistor de puissance T2 afin de déterminer la commande de grille GDRV.

Le circuit auxiliaire 200b comporte de manière préférée des composants électroniques discrets, ce qui permet un réglage précis et sur mesure du comportement du dispositif de commande 200 pour commander un transistor à grille du type MOSFET.

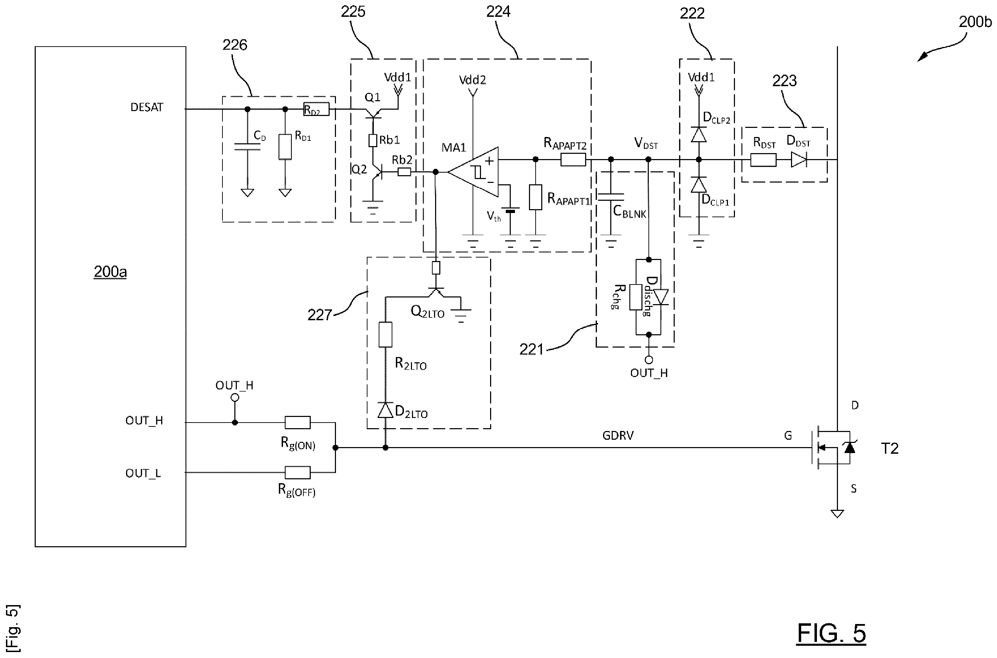

En référence à la figure 5, il est représenté le circuit auxiliaire 200b de manière rapprochée. Le circuit auxiliaire 200b comprend :

- un circuit de comparaison auxiliaire 224 configuré pour réaliser une détection anticipée d'une désaturation,

- un circuit d'inhibition 221 configuré pour stabiliser l'entrée du circuit de comparaison auxiliaire 224,

- un circuit de protection 222,

- un circuit de pinçage 223

- un circuit d'ouverture d'un court-circuit en deux niveaux 227 configuré pour modifier la commande de grille GDRV en cas de détection anticipée,

- un circuit d'adaptation 225 configuré pour augmenter la commande de sortie du circuit de comparaison auxiliaire 224 jusqu'à la tension de désaturation nominale DESAT,

- un circuit de retard 226 configuré pour retarder la commande de sortie du circuit de comparaison auxiliaire 224 avant émission de la tension de désaturation nominale DESAT.

Circuit d'inhibition 221

En référence à la figure 5, le circuit auxiliaire 200b comprend un circuit d'inhibition 221 configuré pour inhiber la détection du circuit de comparaison auxiliaire 224 pendant la durée d'une commutation normale. Cela permet de réduire le risque de fausses détection de panne.

Dans cet exemple, le circuit d'inhibition 221 comprend une capacité d'inhibition $C_{BLNK}$ référencée au potentiel d'alimentation Vss. Le circuit d'inhibition 221 comprend en outre une résistance d'inhibition $R_{chg}$ et une diode d'inhibition $D_{dischg}$ qui sont montées en parallèle. La résistance d'inhibition $R_{chg}$ et la diode d'inhibition $D_{dischg}$ sont connectées toutes les deux entre la capacité d'inhibition $C_{BLNK}$ et la sortie haute OUT_H. Lors de la commande en fermeture ON, la capacité d'inhibition $C_{BLNK}$ se charge lentement par la résistance d'inhibition $R_{chg}$ et se décharge rapidement lors de la commande en fermeture OFF par la diode d'inhibition $D_{dischg}$. En pratique, le circuit d'inhibition 221 génère une rampe de tension de drain VDST croissante lente lors de la commande en fermeture ON et décroissante rapide lors de la commande en ouverture OFF.

Circuit de pinçage 223

Toujours en référence à la figure 5, le circuit auxiliaire 200b comprend un circuit de pinçage 223 (ou écrêteur) appelé également « clamp » en langue anglaise-qui limite la tension $V_{DST}$ en dessous du seuil de détection $V_{th}$ lorsque le transistor T2 est passant normalement et déconnecte le drain du transistor T2 du reste du circuit auxiliaire 200b pour permettre à la rampe de tension $V_{DST}$ de dépasser le seuil de détection $V_{th}$ lorsque le transistor T2 est forcé en désaturation au début d'un court-circuit. Le circuit de pinçage 223 comprend une diode de protection $D_{DST}$ et une résistance de protection $R_{DST}$ connectées en série entre le potentiel $V_{DST}$ et le drain D du transistor à grille T2.
Le circuit de pinçage 223 est configuré pour empêcher de déclencher une détection de court-circuit quand le transistor T2 est correctement saturé et autoriser cette même détection de court-circuit lorsque le transistor T2 est désaturé par un court-cicuit. En particulier, le circuit de protection 222 permet de bloquer la rampe de tension $V_{DST}$ à la tension de désaturation du transistor à grille T2 durant la phase de commande en fermeture ON.
Comme cela sera présenté par la suite, il est ainsi possible de détecter la présence d'un courant de court-circuit en comparant le potentiel VDST à un seuil prédéterminé à l'issue ou après la phase commande en fermeture ON du transistor T2 afin de détecter si celui-ci est éventuellement désaturé.

Circuit de protection 222

De manière préférée, le circuit auxiliaire 200b comprend un circuit de pinçage protection 222. Le circuit de protection 222 est monté entre le circuit d'inhibition 221 et le drain D du transistor à grille T2.
Le circuit de protection 222 comprend deux diodes de pinçage $D_{CLP1}$, $D_{CLP2}$ connectées en série. La cathode de la première diode de pinçage $D_{CLP1}$ et l'anode de la deuxième diode de pinçage $D_{CLP2}$ sont connectées à la capacité d'inhibition $C_{blnk}$, ainsi qu'à la diode de protection $D_{DST}$ par l'intermédiaire de la résistance de protection $R_{DST}$. L'anode de première diode de pinçage $D_{CLP1}$ est connectée au potentiel d'alimentation Vss et la cathode de la deuxième diode de pinçage $D_{CLP2}$ au premier potentiel positif Vdd1.

Circuit de comparaison auxiliaire 224

En référence à la figure 5, le circuit auxiliaire 200b comprend un circuit de comparaison auxiliaire 224 configuré pour comparer la tension $V_{DST}$, c'est-à-dire une tension représentative de la tension de drain $V_{DS}$, à un seuil de désaturation avancé $V_{th}$. Un tel seuil de désaturation avancé $V_{th}$, dont la valeur est plus faible que le seuil de désaturation nominal $V_{DSth}$ du circuit principal 200a, permet de réaliser une détection rapide et anticipée d'une désaturation par comparaison au circuit principal 200a, ce qui permet de protéger de manière réactive le transistor de puissance T2 de type MOSFET SiC comme cela sera présenté par la suite.
Le circuit de comparaison auxiliaire 224 comprend un comparateur, ici un amplificateur opérationnel, qui est configuré pour activer un circuit d'ouverture d'un court-circuit en deux niveaux 227 permettant de commander la commande de grille GRDV comme cela sera présenté par la suite. Le comparateur est référencé au potentiel d'alimentation Vss.
Dans cet exemple, le circuit de comparaison auxiliaire 224 comprend un pont diviseur pour adapter la tension $V_{DST}$. Dans cet exemple, le pont diviseur comprend deux résistance $R_{ADAPT1}$, $R_{ADPT2}$.
Le circuit de comparaison 224 permet d'activer le circuit d'ouverture d'un court-circuit en deux niveaux 227 après une durée courte (de l'ordre de quelques 10ns) suite à la détection d'une désaturation anticipée. Cette durée est plus courte par comparaison à celle du circuit de comparaison nominale 214 du circuit principal 200a. De manière préférée, le comparateur utilisé est choisi très rapide. A titre d'exemple, un comparateur d'un circuit principal standard de type « NCD57000 - Isolated High Current IGBT Gate Driver - ONSEMI - NCD57000/D - June 2022 - Rev. 4 » possède un temps de réaction très lent (320ns).

Circuit d'adaptation 225

De manière préférée, en référence à la figure 5, le circuit auxiliaire 200b comprend un circuit d'adaptation 225 configuré pour adapter la tension de sortie du circuit de comparaison auxiliaire 224 à l'entrée de désaturation nominale DESAT du circuit principal 200a. En effet, la tension de sortie du circuit de comparaison auxiliaire 224 est un signal logique qui n'est pas compatible avec le circuit principal 200a qui est conçu pour détecter des tensions de désaturation d'un transistor IGBT de plus fortes valeurs. Le circuit d'adaptation 225 permet ainsi de compenser, en amplitude et en référence, l'action du circuit de comparaison 224.

Dans cet exemple, en référence à la figure 5, le circuit d'adaptation 225 est utilisé pour effectuer un changement de référence de tension par un montage à sortie logique collecteur/drain ouvert connu sous sa désignation anglaise « open collector » alimenté par le premier potentiel positif Vdd1. Le circuit d'adaptation 225 comprend dans cet exemple, deux transistors Q1, Q2 et deux résistances Rb1, Rb2.

Circuit de retard 226

De manière préférée, en référence à la figure 5, le circuit auxiliaire 200b comprend un circuit de retard 226 configuré pour retarder la tension de sortie du circuit de comparaison auxiliaire 224 avant transmission à l'entrée de désaturation nominale DESAT du circuit principal 200a. En effet, comme la détection d'une désaturation est réalisée de manière anticipée par le circuit auxiliaire 200b, la tension de sortie du circuit de comparaison auxiliaire 224 est fournie de manière anticipée via l'entrée de désaturation nominale DESAT au circuit principal 200a. Le circuit d'adaptation 225 permet ainsi de compenser, en appliquant un retard, l'action du circuit de comparaison 224.

Dans cet exemple, le circuit de retard 226 est référencé au potentiel de la source S du transistor T2 et introduit un délai de retard prédéterminé entre la commutation du signal générée par le circuit de comparaison 224 lorsqu'une désaturation est détectée et l'entrée de désaturation nominale DESAT du circuit principal 200a. Le délai de retard est fixe et réglé de manière avantageuse pour correspondre à la durée d'un palier intermédiaire pendant lequel le courant de court-circuit est contrôlé par le circuit d'ouverture en deux niveaux 227 comme cela sera présenté par la suite. Au-delà de la durée de ce délai de retard, l'entrée de désaturation nominale DESAT est activée ce qui permet au circuit principal 200a de réaliser ses fonctions comme dans l'art antérieur, c'est-à-dire, une détection de défaut FLT, une commande STO, une isolation, une mémorisation des défauts à travers la barrière d'isolation, un réarmement, etc. Du point de vue du circuit principal 200a, la détection anticipée du court-circuit par le circuit auxiliaire 200b est transparente.

Dans cet exemple, en référence à la figure 5, le circuit de retard 226 comprend deux résistances $R_{D1}$, $R_{D2}$ et une capacité $C_D$. Il va de soi que la structure du circuit de retard 226 pourrait être différente.

Circuit d'ouverture d'un court-circuit en deux niveaux 227

De manière préférée, en référence à la figure 5, le circuit auxiliaire 200b comprend un circuit d'ouverture d'un court-circuit en deux niveaux 227 configuré pour forcer un palier de tension intermédiaire lors de la commande d'ouverture d'un court-circuit. Le palier de tension intermédiaire (appelé aussi premier palier) est inférieur à la tension de grille GRDV traditionnelle (en général Vdd1) pour commander le transistor de puissance T2 en fermeture ON. Cela permet d'utiliser le transistor T2 pour contrôler le courant de court-circuit et limiter les surtensions à l'ouverture du court-circuit. Dans cet exemple, le circuit d'ouverture d'un court-circuit en deux niveaux 227 comprend un transistor $Q_{2LTO}$, une diode $D_{2LTO}$ et une résistance $R_{2LTO}$. Le palier de tension intermédiaire est réalisé par un pont diviseur, formé par les résistances $R_{2LTO}$ et $R_{g(ON)}$, qui vient diviser la tension de commande à l'état ON (Vdd1) du transistor de puissance T2.

Le palier de tension intermédiaire est inférieur à la tension de commande à l'état passant et supérieur (ou égal) à la tension de seuil du transistor de puissance T2. Le palier de tension intermédiaire est activé dès la détection d'un court-circuit par le module de comparaison rapide 224, ce qui permet une grande réactivité. Lorsque la sortie du circuit de comparaison 224 bascule de Vss à Vdd2, le transistor $Q_{2LTO}$ se ferme et la tension de grille GRDV est égale à la tension du palier intermédiaire.

Avantages

De manière avantageuse, l'association d'un circuit principal 200a classique pour un transistor à grille du type IGBT avec un circuit auxiliaire 200b permet de tirer avantage des fonctions classiques et robustes du circuit principal 200a tout en bénéficiant de fonctions évoluées via le circuit auxiliaire 200b pour permettre une compatibilité avec un transistor à grille du type MOSFET SiC.

Le circuit auxiliaire 200b permet une détection réactive d'une désaturation, ce qui permet l'activation rapide du circuit d'ouverture du court-circuit en deux niveaux 227. Le courant de court-circuit est ainsi maitrisé du fait de la rapidité de détection couplée à la rapidité de la commande de grille en deux niveaux du transistor de puissance T2 qui est compatible avec un transistor du type MOSFET SiC. De manière avantageuse, il n'est pas nécessaire d'ajouter un mécanisme supplémentaire pour bloquer complètement le transistor avec la tension de commande au blocage Vss à la fin du palier intermédiaire car le mécanisme interne du circuit principal 200a est utilisé à cet usage. En effet, la sortie haute OUT_H et la sortie basse OUT_L fournies pas le circuit principal 200a sont activées en mode STO par la détection de désaturation anticipée, adaptée en amplitude pour être compatible des niveaux requis par le circuit principal 200a, avec de plus un retard réglable permettant de configurer la durée de palier intermédiaire.

De manière avantageuse, en référence à la figure 5, le circuit d'inhibition 221 est activé par la sortie haute OUT_H qui commande au même instant la commande de fermeture ON du transistor T2 et le démarrage de la rampe de tension $V_{dst}$ réalisée par la charge de la capacité d'inhibition $C_{BLNK}$ par OUT_H au travers de la résistance d'inhibition $R_{chg}$. Ainsi il n'y a pas de retard entre la commande ON du transistor T2 et le début de la rampe de tension. Cela permet de minimiser la durée de la phase d'ouverture d'un court-circuit durant laquelle le courant de court-circuit n'est pas encore contrôlé par le transistor T2.

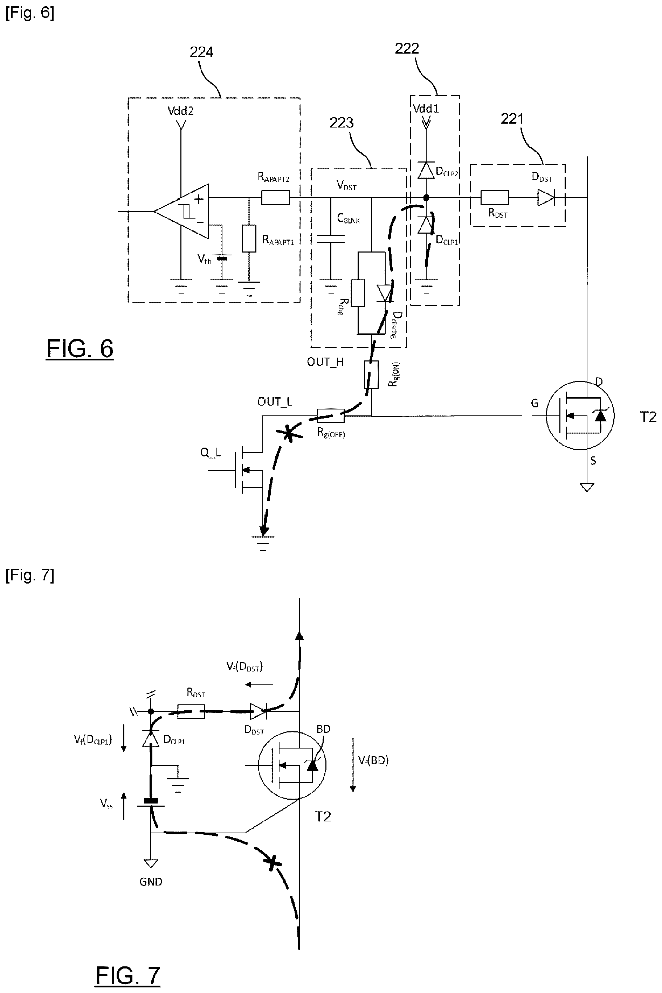

De manière avantageuse, en référence à la figure 5, le circuit de comparaison 224 est référencé au potentiel d'alimentation Vss. Comme illustré à la figure 6, cela permet de le protéger avec une diode de protection $D_{CPL1}$ sans que celle-ci ne puisse faire circuler de courant dans la résistance d'inhibition $R_{chg}$ ni faire surconsommer l'alimentation Vss avec la diode d'inhibition $D_{DISCHG}$ lors de la commande OFF du transistor car son anode est connectée à Vss comme la source du transistor Q_L.

De manière avantageuse, en référence à la figure 4, le potentiel d'alimentation Vdd1 est identique au potentiel GND ce qui permet de n'utiliser qu'une seule source d'alimentation pour générer les potentiels Vss et Vdd1 qui, dès lors, se confondent. Cela est avantageusement rendu possible lorsque le circuit d'inhibition 221 et le circuit de comparaison 224 sont référencés au potentiel d'alimentation Vss et lorsque la grille du transistor de puissance MOSFET SiC est bloquée avec une tension négative de l'ordre de -5V (dans cet exemple -Vss) comme illustré à la figure 6. Le blocage du transistor à grille T2 en négatif est propre à l'utilisation de MOSFET SiC de forte puissance dans une configuration bras de pont.

Cela permet de tirer avantage de la capacité grille-source du transistor à grille T2 pour limiter la vitesse des variations de commande de grille lors du passage du palier de tension intermédiaire à la tension de seuil grâce au circuit d'ouverture en deux niveaux 227 mais également lors de l'ouverture STO. Cela permet de limiter la pente de la commande de grille GDRV, ce qui est avantageux et limite le risque de défaut.

En outre, en référence à la figure 7, le référencement de la première diode de protection $D_{CLP1}$ à la tension d'alimentation Vss est avantageux. La tension d'alimentation Vss permet de bloquer les diodes $D_{CLP1}$ et $D_{DST}$ durant la phase de redressement passif (fonctionnement du MOSFET dans le 3eme quadrant) de l'onduleur OND et ainsi d'empêcher le courant de drain de passer au travers des diodes $D_{CLP1}$ et $D_{DST}$ au risque de les endommager. En effet la tension de seuil ou « forward », notée $V_F$, de la diode de body BD du transistor de puissance T2 est plus grande s'il est du type MOSFET SiC que s'il est du type IGBT. Ainsi, grâce au référencement à la tension d'alimentation Vss selon l'invention, les diodes $D_{CLP1}$ et $D_{DST}$ demeurent bloquées pendant les phases de fonctionnement dans le 3eme quadrant si la tension d'alimentation Vss (négative) est choisie de manière à respecter la formule suivante :

**[Math 1]**

$$V_F(D_{CLP1}) + V_F(D_{DST}) - V_{ss} > V_F(BD)$$

1<sup>ère</sup> variante : circuit de buffer 228

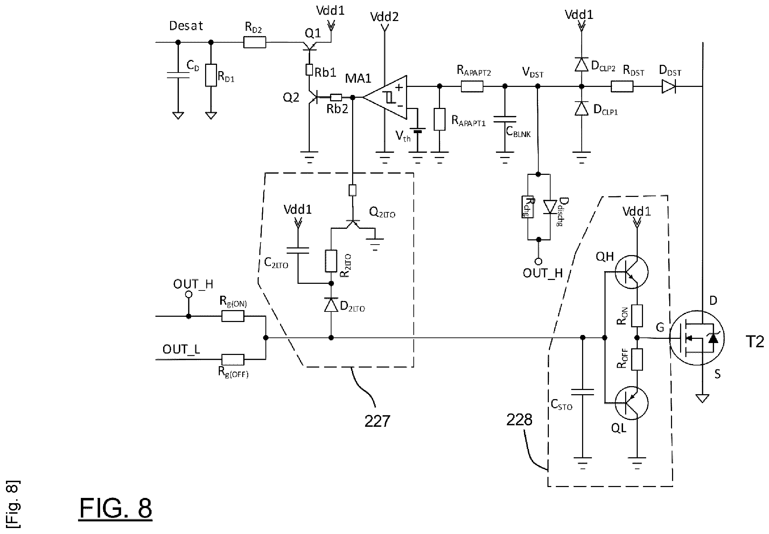

De manière avantageuse, en référence à la figure 8, le dispositif de commande 200 est configuré pour commander plusieurs transistors de puissance à grille en parallèle, du type IGBT ou MOSFET Sic.

Selon un aspect, en référence à la figure 8, le dispositif de commande 200 comprend un circuit de buffer 228 pour augmenter la commande de grille GDRV de la grille du ou des transistors de puissance à commander. Dans cet exemple, le circuit de buffer 228 est du type push-pull. Le circuit de buffer 228 comprend dans l'exemple deux transistors bipolaires QH, QL et deux résistances Ron, Roff. Le circuit de buffer 228 comprend en outre une capacité $C_{STO}$ qui est connectée entre la base de QL et le collecteur de QL lui-même connecté au potentiel de référence Vss afin de limiter la vitesse de décroissance de la commande de grille GDRV à l'ouverture du courant à la fin du palier intermédiaire.

De préférence, toujours en référence à la figure 8, le circuit d'ouverture en deux niveaux 227 comprend une capacité additionnelle $C_{2LTO}$ connectée entre la cathode de la diode $D_{2LTO}$ et la première tension positive Vdd1. La capacité additionnelle $C_{2LTO}$ permet de limiter la vitesse de décroissance de la commande de grille GDRV durant la transition entre la tension ON normale à la tension du palier intermédiaire et ainsi de limiter la surtension à l'ouverture du courant de court-circuit. La capacité additionnelle $C_{2LTO}$ permet de limiter la vitesse de variation de la commande de grille GDRV lors d'une commande en ouverture OFF en cas de détection anticipée.

Ainsi, le circuit auxiliaire 200b conserve la capacité à limiter la vitesse de décroissance de la commande de grille GDRV à la fin du palier intermédiaire dans le cas de l'utilisation d'un circuit de buffer 228 du fait de la capacité additionnelle $C_{STO}$ qui permet de contrôler la commutation en fin du palier intermédiaire. La capacité $C_{STO}$ permet d'interagir avec la résistance $R_{STO}$ interne du circuit principal 200a, de façon à limiter la vitesse de variation de l'ouverture du courant à la fin du deuxième palier. Cela permet avantageusement de pouvoir bénéficier de la fonction STO du circuit principal 200a ainsi que de la fonction d'ouverture en deux niveaux du circuit auxiliaire 200b.

Selon un aspect, la résistance $R_{STO}$ n'étant utilisée que pour l'ouverture lente à la fin du palier intermédiaire lorsque le courant de court-circuit a déjà fortement diminué, il est avantageux de choisir la capacité $C_{STO}$ avec une faible valeur de manière à ne pas modifier les vitesses de commutation normales et donc les pertes lors des commutations normales.

De préférence, la capacité $C_{2LTO}$ est connectée entre le premier potentiel positif Vdd1 et la cathode diode $D_{STO}$. Ainsi elle est polarisée à une tension constante proche de zéro (la tension forward de la diode $D_{STO}$). Elle possède ainsi une grande fiabilité et ne nécessite aucun courant de charge à la mise sous tension.

De manière avantageuse, la diode $D_{2LTO}$ et la capacité redressent la tension OUT_H pendant les commutations normales lorsque le transistor $Q_{2LTO}$ est ouvert. En fonctionnement normal, la sortie haute OUT_H commute entre la tension d'alimentation Vss et la première tension positive Vdd1 à une fréquence de découpage pouvant varier selon les applications de 1 kHz à 100kHz. La capacité $C_{2LTO}$ est donc maintenue déchargée à chaque commutation en fermeture ON à la tension crête de la sortie haute OUT_H, c'est à dire à la première tension positive Vdd1 en négligeant la chute de tension de la diode $D_{2LTO}$ sans générer de pertes dans la résistance $R_{g(ON)}$.

La capacité $C_{STO}$, quant à elle, se charge à la première tension positive Vdd1 à chaque début de commutation en fermeture ON, et se décharge à la tension d'alimentation Vss au début de chaque commutation en ouverture OFF au travers des résistances $R_{g(ON)}$ et $R_{g(OFF)}$. Ainsi, assez rapidement au début d'une commutation en fermeture ON, les deux capacités sont à la même première tension positive Vdd1. Lorsque le circuit d'ouverture en deux niveaux 227 est activé par la commande en fermeture ON du transistor $Q_{2LTO}$, les deux capacités se trouvent en parallèle ralentissent la variation de la tension vers le palier de tension intermédiaire de formule approchée suivante :

[Math 2]

$$V_{2LTO} \approx V_{dd1} \frac{R_{2LTO}}{R_{2LTO} + R_{g(ON)}}$$

Avec la constante de temps suivante :

[Math 3]

$$\tau_{2LTO} = \frac{R_{STO} R_{2LTO}}{R_{STO} + R_{2LTO}} (C_{STO} + C_{2LTO})$$

Variantes

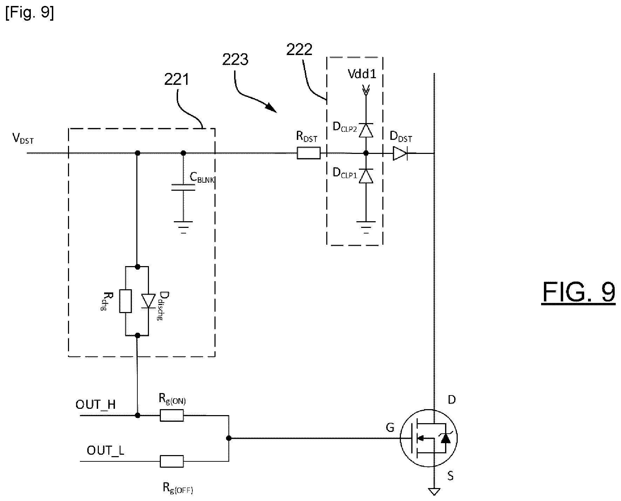

Dans une autre variante, en référence à la figure 9, comme la tension d'alimentation Vss est négative par rapport au potentiel de la source S, le circuit de protection 222 destiné à se prémunir de surtensions de la tension $V_{DST}$ peut être réalisé en connectant la cathode de la première diode $D_{CLP1}$ et l'anode de la deuxième diode $D_{CLP2}$ au potentiel reliant la diode $D_{DST}$ et la résistance $R_{DST}$. Autrement dit, par rapport à la forme de réalisation de la figure 5, la résistance $R_{DST}$ est positionnée en amont des diodes $D_{CLP1}$ et $D_{CLP2}$, c'est-à-dire, entre le circuit d'inhibition 221 et le circuit de pinçage 222.

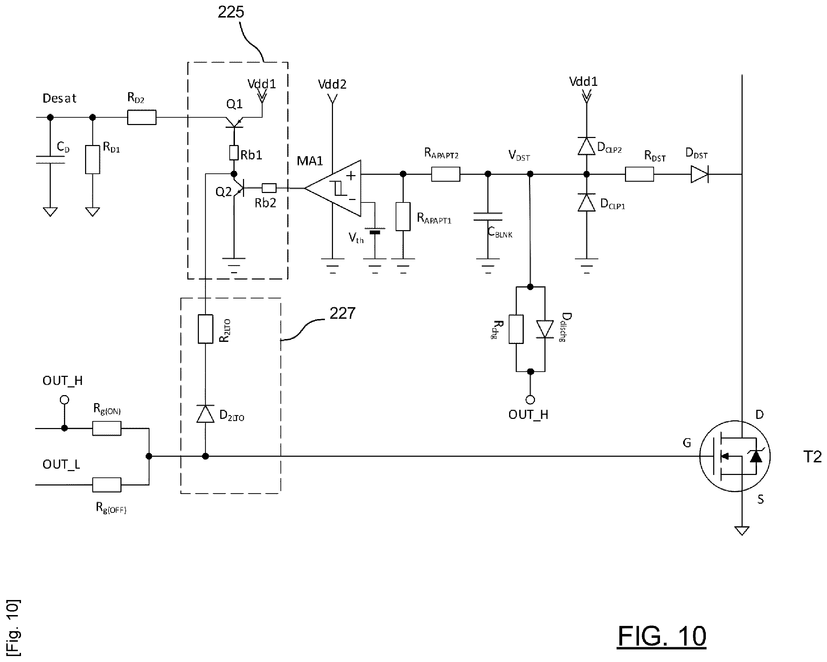

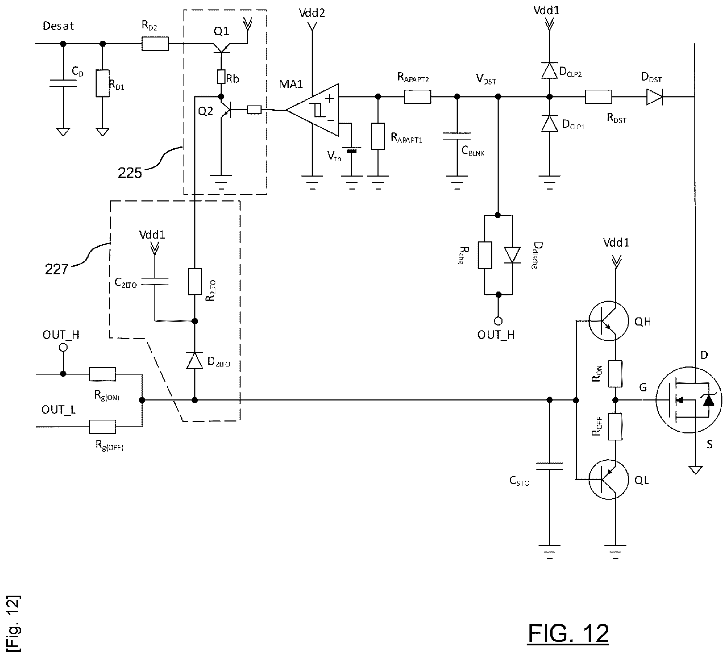

Dans une autre variante, en référence à la figure 12, le circuit d'ouverture en deux niveaux 227 est commandé par le transistor Q2 du circuit d'adaptation 225, en particulier, par le transistor Q2. Cela permet avantageusement d'utiliser moins de composants en communalisant les transistors Q2 et $Q_{LTO}$. Il est trivial que le même arrangement fonctionne sans utiliser de capacité C2LTO (figure 10).

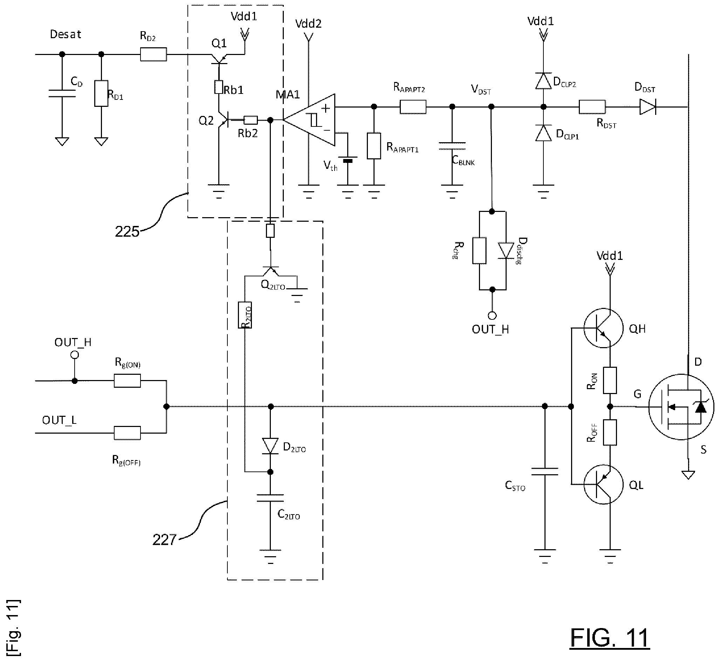

Dans une autre variante, en référence à la figure 11, la capacité $C_{2LTO}$ du circuit d'ouverture en deux niveaux 227 est reliée entre la cathode de $D_{2LTO}$ et la tension d'alimentation Vss. Cela permet avantageusement à la capacité $C_{2LTO}$ d'être chargée avant l'activation du circuit en deux niveaux 227 et donc ne pas générer d'appel de courant sur l'alimentation Vdd1 à l'activation du circuit d'ouverture en deux niveaux.

Dans une autre variante, en référence à la figure 8, le circuit d'ouverture en deux niveaux 227 est commandé par le transistor $Q_{2LTO}$ de type MOSFET. Cela permet avantageusement de limiter le courant que doit fournir le circuit comparateur MA1.

Dans une autre variante, en référence à la figure 12, le circuit d'ouverture en deux niveaux 227 est commandé par le transistor Q2 de type MOSFET. Cela permet avantageusement de limiter le courant que doit fournir le circuit comparateur MA1.

**Revendications**

1. Circuit auxiliaire (200b) pour un dispositif de commande (200) d'un transistor de puissance (T2), le circuit auxiliaire (200b) étant configuré pour se connecter à la grille et au drain du transistor à grille (T2), le circuit auxiliaire (200b) étant configuré pour recevoir d'un circuit principal (200a) du dispositif de commande (200) au moins une commande de commutation (OUT_H, OUT_L) et émettre une commande de grille (GRDV) du transistor à grille (T2), le circuit auxiliaire (200b) étant configuré pour émettre une tension de désaturation nominale (DESAT), représentative d'un court-circuit, au circuit principal (200a) de manière à réaliser une détection nominale d'une désaturation, circuit auxiliaire (200b) **caractérisé par le fait qu'**il comporte :

   - au moins un circuit de comparaison auxiliaire (224) configuré pour comparer une tension représentative d'une tension de drain ($V_{DS}$), à un seuil de désaturation avancé ($V_{th}$) de manière à réaliser une détection anticipée d'une désaturation, le circuit auxiliaire (200b) étant configuré pour modifier la commande de grille (GDRV) en cas de détection anticipée et un circuit de retard (226) configuré pour retarder la commande de sortie du circuit de comparaison auxiliaire (224) avant émission de la tension de désaturation nominale (DESAT).

2. Circuit auxiliaire (200b) selon la revendication 1, comprenant un circuit d'ouverture en deux niveaux (227) configuré pour définir un palier de tension intermédiaire lors d'une commande en ouverture (OFF) en cas de détection anticipée

3. Circuit auxiliaire (200b) selon l'une des revendications 1 à 2, comprenant un circuit d'adaptation (225) configuré pour augmenter la commande de sortie du circuit de comparaison auxiliaire (224) jusqu'à la tension de désaturation nominale (DESAT).

4. Circuit auxiliaire (200b) selon l'une des revendications 1 à 3, comprenant un circuit d'inhibition (221) configuré pour générer un retard de stabilisation de la tension représentative de la tension de drain ($V_{DS}$) pour le circuit de comparaison (224).

5. Circuit auxiliaire (200b) selon les revendications 2 et 3, dans lequel le circuit d'ouverture en deux niveaux (227) est commandé par la sortie du circuit d'adaptation (225).

6. Dispositif de commande (200) d'un transistor à grille (T2) comprenant un circuit principal (200a) et un circuit auxiliaire (200b) selon l'une des revendications 1 à 5, le circuit auxiliaire (200b) étant configuré pour recevoir du circuit principal (200a) du dispositif de commande (200) au moins une commande de commutation (OUT_H, OUT_L), le circuit auxiliaire (200b) étant configuré pour émettre une tension de désaturation nominale (DESAT) représentative d'un court-circuit au circuit principal (200a) de manière à réaliser une détection nominale d'une désaturation.

7. Dispositif de commande (200) selon la revendication 6, dans lequel le circuit principal (200a) comporte un circuit de comparaison (214) configuré pour comparer la tension de désaturation nominale (DESAT) à un seuil de désaturation nominal ($V_{DSth}$) de manière à réaliser une détection nominale d'une désaturation, le circuit principal (200a) étant configuré pour modifier la commande de commutation (OUT_H, OUT_L) en cas de détection nominale.

8. Convertisseur électrique (OND) comprenant une pluralité de transistors à grille (T1-T6), au moins un transistor à grille (T2) étant associé à un dispositif de commande (200) selon l'une des revendications 6 à 7.

9. Procédé de commande (200) d'un transistor de puissance (T2) par un circuit auxiliaire (200b) selon l'une des revendications 1 à 5, le procédé comprenant des étapes consistant à :

   - Comparer une tension représentative d'une tension de drain ($V_{DS}$), à un seuil de désaturation avancé ($V_{th}$) de manière à réaliser une détection anticipée d'une désaturation, et
   - Modifier la commande de grille (GDRV) en cas de détection anticipée.

[Fig. 1]

FIG.1

[Fig. 2]

FIG. 2

[Fig. 3]

# FIG. 3

BAT

200

PWM_T2 → | Vee | Vcc | GND | DESAT | OUT — T2

PWM_T1 → | Vee | Vcc | GND | DESAT | OUT — T1

200

PWM_T4 → | Vee | Vcc | GND | DESAT | OUT — T4

PWM_T3 → | Vee | Vcc | GND | DESAT | OUT — T3

200

PWM_T6 → | Vee | Vcc | GND | DESAT | OUT — T6

PWM_T5 → | Vee | Vcc | GND | DESAT | OUT — T5

B1

B2

B3

OND

M

[Fig. 4]

FIG. 4

[Fig. 5]

FIG. 5

[Fig. 6]

FIG. 6

[Fig. 7]

FIG. 7

[Fig. 8]

**FIG. 8**

[Fig. 9]

FIG. 9

[Fig. 10]

**FIG. 10**

OUT_L

OUT_H

R_g(OFF)

R_g(ON)

Desat

C_D

R_D1

R_D2

225

227

D_2LTO

R_2LTO

Q2

Q1

Rb1

Rb2

Vdd1

MA1

Vdd2

V_th

R_APAPT1

R_APAPT2

C_BLNK

V_DST

R_dh8

OUT_H

D_disdh8

Vdd1

D_CIP2

D_CIP1

R_DST

D_DST

G

S

D

T2

[Fig. 11]

**FIG. 11**

[Fig. 12]

FIG. 12

Europäisches
Patentamt

European
Patent Office

Office européen
des brevets

# RAPPORT DE RECHERCHE EUROPEENNE

**Numéro de la demande**

EP 25 17 8677

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2018/309433 A1 (VOLKE ANDREAS [DE] ET AL) 25 octobre 2018 (2018-10-25) * alinéa [0056] - alinéa [0069]; figures 1B, 2A, 2B, 3 * ----- | 1-9 | INV. H03K17/082 H02M1/00 H02M1/08 H03K17/16 |

| | DOMAINES TECHNIQUES RECHERCHES (IPC) |
|---|---|
| | H03K H02M |

Le présent rapport a été établi pour toutes les revendications

| Lieu de la recherche | Date d'achèvement de la recherche | Examinateur |
|---|---|---|
| La Haye | 19 septembre 2025 | Fermentel, Thomas |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 25 17 8677

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

19-09-2025

| Document brevet cité au rapport de recherche | Date de publication | Membre(s) de la famille de brevet(s) | Date de publication |
|---|---|---|---|
| US 2018309433 A1 | 25-10-2018 | CN 107276574 A | 20-10-2017 |
| | | EP 3229373 A1 | 11-10-2017 |
| | | US 2017294907 A1 | 12-10-2017 |
| | | US 2018309433 A1 | 25-10-2018 |

EPO FORM P0460

Pour tout renseignement concernant cette annexe : voir Journal Officiel de l'Office européen des brevets, No.12/82

**EP 4 657 756 A1**

## RÉFÉRENCES CITÉES DANS LA DESCRIPTION

**Documents brevets cités dans la description**

- US 20180309433 A1